# EUROPEAN PATENT APPLICATION

(11) **EP 4 667 412 A1**
(43) Date of publication of application: **24.12.2025**
(21) Application number: 24183128.8
(22) Date of filing: 19.06.2024
(51) Int. Cl.: B81B 3/00, B81B 7/00

(54) **MEMS DEVICE WITH MOTION LIMITER**

(71) Applicant: Murata Manufacturing Co., Ltd., Nagaokakyo-shi, Kyoto 617-8555 (JP)
(72) Inventor: SANDVIK, Kim, 02650 Espoo (FI); LIUKKU, Matti, 00320 Helsinki (FI)
(74) Representative: Boco IP Oy Ab

(57) **Abstract**

A microelectromechanical device comprising a mobile mass element, a fixed structure which is adjacent to the mass element and a motion limiter comprising a first stopper element and a second stopper element. The motion limiter is configured to resist further movement of the main body of the mass element toward the fixed structure with a first spring constant when a first threshold has been crossed but a second threshold has not yet been crossed. The motion limiter is configured to resist further movement of the main body of the mass element toward the fixed structure with a second spring constant after a second threshold has been crossed.

## Description

### FIELD OF THE DISCLOSURE

The present disclosure relates to microelectromechanical (MEMS) devices, and more particularly to motion limiters. The present disclosure further concerns motion limiters that that act in multiple stages.

### BACKGROUND OF THE DISCLOSURE

Microelectromechanical (MEMS) devices such as accelerometers and gyroscopes often comprise a mass element which is suspended from fixed anchors with a flexible suspension structure which allows the mass element to move in relation to adjacent fixed structures.

Direct physical contact between the mass element and the fixed structures is often undesirable because it may disturb the operation of the device. The mass element and its suspension structure can be dimensioned so that direct contact does not occur in regular operation. However, exceptional external shocks may still displace the mass element so much that it comes into direct contact with fixed structures, causing structural damage, stiction, electrical short-circuits or other faults.

Motion limiters can be implemented in MEMS devices to reduce or prevent these harmful consequences. A motion limiter may for example comprise a bump which is attached to the fixed structure and extends from the fixed structure toward the mass element. The gap between the bump and the mass element may be so narrow in the expected direction of motion that the bump will be the first part which comes into contact with the fixed structure in the event of an external shock.

The motion limiter can be designed to minimize damage for example by placing bumps in unsensitive areas of the mass element. Motion limiters can also be designed to soften the impact between the mass element and the fixed structure.

Document US10502759 discloses a two-stage motion limiter.

### BRIEF DESCRIPTION OF THE DISCLOSURE

An object of the present disclosure is to provide an apparatus which alleviates the above disadvantage. The object of the disclosure is achieved by an arrangement which is characterized by what is stated in the independent claim. The preferred embodiments of the disclosure are disclosed in the dependent claims.

The disclosure is based on the idea of utilizing a multi-stage motion limiter where the second impact and possible subsequent impacts increase the spring constant of the motion limiter.

### BRIEF DESCRIPTION OF THE DRAWINGS

In the following the disclosure will be described in greater detail with reference to the accompanying drawings, in which
Figures 1a 1c illustrate a mass element with a motion limiter.
Figures 2a - 2c illustrate a first out-of-plane embodiment.
Figures 3a - 3c illustrate a second out-of-plane embodiment.
Figures 4a - 4b illustrate other mass elements with motion limiters.
Figures 5a - 5c illustrate a first in-plane embodiment.
Figures 6a - 6b illustrate a second in-plane embodiment.
Figures 7a - 7d illustrate a third in-plane embodiment.

### DETAILED DESCRIPTION OF THE DISCLOSURE

This disclosure describes a microelectromechanical device comprising a device layer which defines a device plane, and a mobile mass element in the device layer. The mass element comprises a main body. The microelectromechanical device also comprises a fixed structure which is adjacent to the mass element. This device also comprises a motion limiter on the mass element. The motion limiter comprises a first stopper element and a second stopper element.

The motion limiter may be configured to bring the first stopper element into contact with the fixed structure when the mass element crosses a first threshold while moving toward the fixed structure. The motion limiter may also be configured to bring the second stopper element into contact with the fixed structure when the mass element crosses a second threshold while moving toward the fixed structure. The mass element may be closer to the fixed structure at the second threshold than at the first threshold.

The motion limiter may be configured to resist further movement of the main body of the mass element toward the fixed structure with a first spring constant when the first threshold has been crossed but the second threshold has not yet been crossed. The motion limiter may also be configured to resist further movement of the main body of the mass element toward the fixed structure with a second spring constant after the second threshold has been crossed. The first spring constant may be smaller than the second spring constant.

Additionally or alternatively, the motion limiter may be configured to move the second stopper element in relation to the main body of the mass element after the first stopper element has come into contact with the fixed structure, so that, between the first and second thresholds, the relative velocity between the second stopper element and the fixed structure is less than the relative velocity between the main body of the mass element and the fixed structure

The first and second thresholds may alternatively be called first and second limits. The term "threshold" refers in this disclosure to a value below which a given stage of the motion limiter is not active, and above which said stage becomes active. In other words, the first stage of the motion limiter may be triggered at the first threshold, the second at the second threshold, and so on. As explained in more detail below, the variable from which the value is measured may for example be a rotation angle of the mass element or a displacement distance of the mass element.

The microelectromechanical device may be configured so that the mass element does not cross any threshold in normal operation. The stopper elements on the mass element do then not come into contact with any fixed structure. But in the case of an external shock, the first threshold may be crossed. The first stage of the motion limiter is then activated, and the motion limiter begins to retard the motion of the mass element.

In some cases, the action of the motion limiter in the first stage may be sufficient to stop the movement of the mass element toward the fixed structure. The second threshold will in that case not be reached. This disclosure is primarily concerned with the action of the motion limiter between the first and second thresholds, and in some cases also between the second threshold and subsequent (third, fourth, etc.) thresholds.

The motion limiter may be a flexible motion limiter. The force by which the motion limiter resists further movement of the mass element, both in the first stage and in the second stage, may be spring force. Since the motion limiter does not rigidly prevent further movement of the mass element at any threshold, the impact which occurs at the first and second thresholds may be smaller than the impact which would take place if the main body of the mass element would come into contact with a fixed structure. The motion limiter described in this disclosure therefore reduces the risk of damage due to impact forces.

In the motion limiter described in this disclosure, the retardation of the motion of the mass element is not the only consequence of the first contact between the first stopper element and the fixed structure. In addition to that retardation, this contact also begins to shift the second stopper element in the same direction where the fixed structure is forcing the first stopper element. This action may for example be created by fixing the first and stopper elements to the same flexible spring or flexible connector, as described in more detail below. The second stopper element may therefore be turning away from the direction of impact even before it comes into contact with the fixed structure, which provides an extra soft impact (due to lower relative velocity) at the second threshold. The same idea can be expanded to third, fourth, fifth etc. thresholds.

The figures of this disclosure illustrate microelectromechanical devices where a mobile mass element lies in an xy-plane or has moved out of the xy-plane. The xy-plane may for example be defined by a device layer where the mass element has been formed. The xy-plane may also be called the device plane. The device layer may be a device wafer or a device layer which has been deposited onto a flat surface. In the former case, the device wafer may define the xy-plane. The device wafer may have a width in the x-direction, a length in the y-direction, and a thickness in the z-direction. The length / thickness and width / thickness aspect ratios may be much greater than 10 in an unprocessed wafer. The top and bottom faces of the wafer, which face in the positive and negative z-directions, may therefore have a much greater area (length x width) than the other faces of the wafer (length x thickness, width x thickness). In the case of a device layer deposited onto a flat surface, this flat surface may define the xy-plane.

The motion limiter may be configured to limit the motion of the mass element in the z-direction which is perpendicular to the xy-plane. Alternatively, the motion limiter may be configured to limit the motion of the mass element in the x-direction which lies in the xy-plane, or in both the x- and y-directions. These two options will be discussed below. In either case, the fixed structure may comprise one or more fixed stopper bumps which protrude from the main surface of the fixed structure toward the mass element.

In any embodiment presented in this disclosure, the microelectromechanical device may be an accelerometer The mass element 1 may be configured to undergo either of the two motions described above when the microelectromechanical device experiences acceleration. The motion of the mass element may be measured with sense transducers to establish the magnitude of the acceleration. Alternatively, the microelectromechanical device may in any embodiment presented in this disclosure be a gyroscope or a resonator where the mass element 1 is driven into oscillating motion (rotational or linear, as described below) by drive transducers. In any embodiment of this disclosure, the mass element may be made of silicon.

### Out-of-plane motion

The mass element may be configured to move toward the fixed structure in a direction which is perpendicular to the device plane. This out-of-plane motion may be rotational motion about a rotation axis which lies in the device plane. Alternatively, the out-of-plane motion may be linear translation out of the device plane.

In any out-of-plane embodiment presented in this disclosure, the motion limiter may comprise a flexible element which extends between the first stopper element and the second stopper element. The flexible element may also extend to the mass element. The flexible element may be more flexible than the stopper elements. Consequently, the spring constant of the motion limiter in any of its various stages may be determined by the flexibility of the flexible element in that stage.

The mass element may comprise a gap. The motion limiter may comprise a torsionally flexible element which extends across the gap. The first stopper element may be attached to the torsionally flexible element at a first attachment point. The second stopper element may be attached to the torsionally flexible element at a second attachment point.

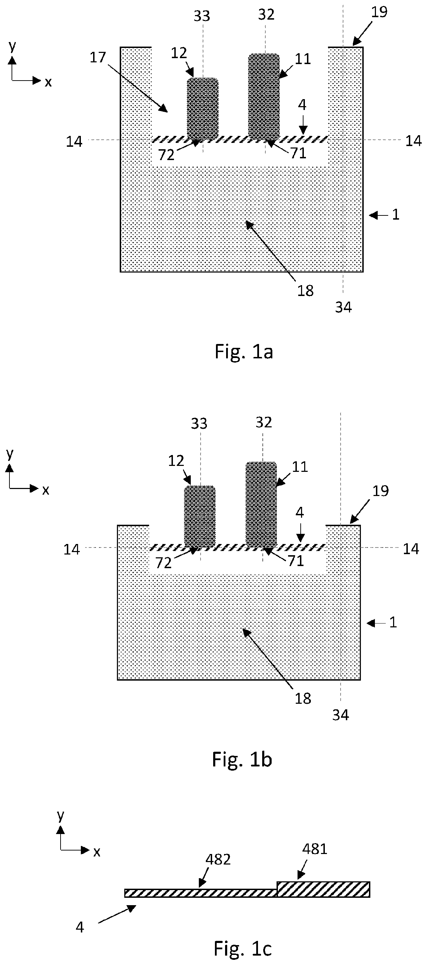

Figure 1a illustrates a mobile mass element 1 in the xy-plane. The mobile mass element 1 may be suspended from an adjacent fixed structure (not illustrated in figure 1a) by a flexible suspension structure (not illustrated). The suspension structure may be configured to allow the mobile mass element 1 to undergo rotational motion about a rotation axis (not illustrated in figure 1a) which lies in the xy-plane, wherein the mass element rotates out of the xy-plane. Alternatively, the suspension structure may be configured to allow the mass element 1 to undergo linear translation in the z-direction.

The mass element 1 in figure 1a also comprises a main body 18 and a gap 17. The illustration is schematic: the main body 18 may in reality be much larger than the gap 17. The gap 17 may be an open gap which lies at one end 19 of the mass element 1, as figure 1a illustrates. The gap 17 is in this case not surrounded by the mass element 1. Alternatively, the gap 17 may be a closed gap. In other words, it may be an opening in the mass element 1, so that the mass element 1 surrounds the gap. This option has not been separately illustrated.

A torsionally flexible element 4 extends across the gap 17, from one side of the gap to the other side of the gap. The torsionally flexible element 4 defines a torsion axis 14, which extends in the x-direction in figures 1a - 1b. Torsional flexibility means that the element 4 can flexibly twist about the torsion axis 14. Different regions of the element 4 may twist to different degrees. In figure 1a, the torsionally flexible element 4 is an elongated torsion spring, but other torsionally flexible elements may alternatively be used.

The microelectromechanical device in figure 1a also comprises a first stopper element 11, attached to the torsionally flexible element 4 at a first attachment point 71. The microelectromechanical device in figure 1a also comprises a second stopper element 12, attached to the torsionally flexible element 4 at a second attachment point 72. The stopper elements 11 and 12 may have the same thickness as the mass element 1 in the z-direction. The stopper elements 11 and 12 may have any size and shape in the xy-plane.

As figures 1a and 1b illustrate, the first stopper element 11 may extend further away from the torsionally flexible element 4 than the second stopper element 12 extends.

The stopper elements may, but do not necessarily have to be, substantially rigid in the z-direction. In particular, they may be so rigid that a force which acts on either stopper element 11 or 12 in the z-direction will twist the flexible element 4 about the torsion axis 14 more than the same force bends said stopper element 11 or 12.

Alternatively, the stopper elements 11 and 12 may be dimensioned so that they bend after the first and second stopper elements 11 and 12 have come into contact with the fixed structure at the first and second thresholds. As figure 1a illustrates, the first and second stopper elements 11 and 12 may be formed within the mass element 1, so that they do not extend beyond the edge of the mass element 1 at the end 19 where they are located. Alternatively, as figure 1b illustrates, the first and second stopper elements 11 and 12 may extend beyond the edge of the mass element 1 at the end 19 where they are located. In other words, the end of the first and/or second stopper element which is not attached to the torsionally flexible element may extend to a y-coordinate which is greater than the y-coordinate of the edge of the mass element 1.

In any out-of-plane embodiment presented in this disclosure, the torsionally flexible element 4 may have uniform width (in the y-direction) and uniform thickness (in the z-direction). Alternatively, as figure 1c illustrates, the torsionally flexible element 4 may have a first element region 481 and a second element region 482, and the width in the device plane of the torsionally flexible element 4 in the first element region 481 may be greater than the width in the device plane of the torsionally flexible element 4 in the second element region 482. Alternatively or additionally, the thickness in the direction perpendicular to the device plane of the torsionally flexible element 4 in the first element region 481 may be greater than the thickness in the direction perpendicular to the device plane of the torsionally flexible element 4 in the second element region 482 (this option has not been illustrated).

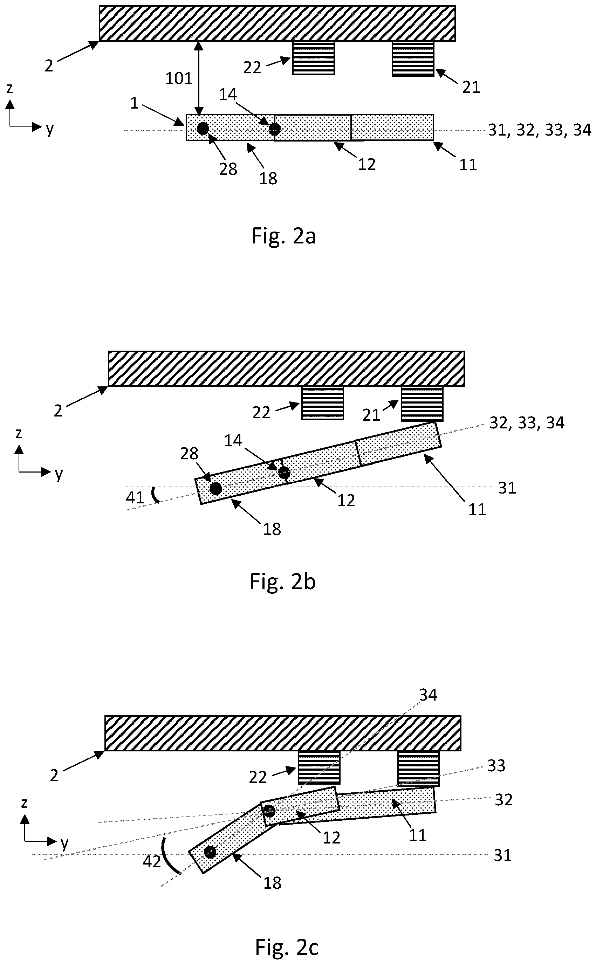

The motion of the mass element 1 toward the fixed structure may comprise rotational motion about a rotation axis. This rotation may occur out of the device plane. This is illustrated in figures 2a - 2c.

The motion limiter may also comprise one or more fixed stopper bumps on the fixed structure which is adjacent to the mass element 1. This is illustrated in figure 2a. The microelectromechanical device comprises a fixed structure 2 which is adjacent to the mass element 1. The mass element 1 may be separated from the fixed structure 2 by a clearance 101 in the z-direction when the mass element 1 is in its rest position. The clearance 101 may be so large that contact between the mass element 1 and the fixed structure 2 is avoided in normal operation. However, contact is still possible if the microelectromechanical device experiences a sudden shock impact.

The fixed structure 2 may be a part of a packaging element, for example a cap wafer or other capping structure which is used to seal the microelectromechanical device. Many other structures could also be used as fixed structures, depending on device design.

In any embodiment in this disclosure, the fixed structure may form a flat surface next to the mass element. Alternatively, in any embodiment in this disclosure (using figure 2a as an example), the fixed structure 2 may comprise fixed stopper bumps 21 and 22 which protrude from the main body of the fixed structure 2 toward the mass element 1, as figure 2a illustrates. In any embodiment presented in this disclosure, the first and second stopper bumps 21 and 22 may be placed so that the first and second stopper elements 11 and 12 make contact with the first and second stopper bumps, respectively, when the first and second thresholds are crossed. In general, protruding stopper bumps allow a wider variety of motion limiter designs to be used than a flat surface allows.

The projection of the first and second stopper bumps 21 and 22 to mass element (in figure 2a, to the xy-plane) may for example partly overlap with the first and second stopper elements 11 and 12. The optimal placement of the first and second stopper bumps 21 and 22 may also depend on the dimensions of these bumps and on the angle of rotation of the proof mass 1 at the first and second thresholds.

The first and second stopper bumps 21 and 22 may in any embodiment in this disclosure have the same dimensions and extend to the same z-coordinate, as figure 2a illustrates. Alternatively, they may have different dimensions and extend to different z-coordinates.

In any embodiment presented in this disclosure, the mass element 1 may in regular operation move without making any contact with the stopper bumps. The motion limiter is inactive as long as there is no contact. The stopper elements move together with the main body of the mass element (and remain in the plane defined by the main body) as long as there is no contact between them and the fixed structure.

The first stage of the motion limiter is activated when a first threshold is crossed, and contact takes place between the first stopper element 11 and the first stopper bump 21. The second stage of the motion limiter is activated when a second threshold is crossed and the second stopper element 12 comes into contact with the second stopper bump 22.

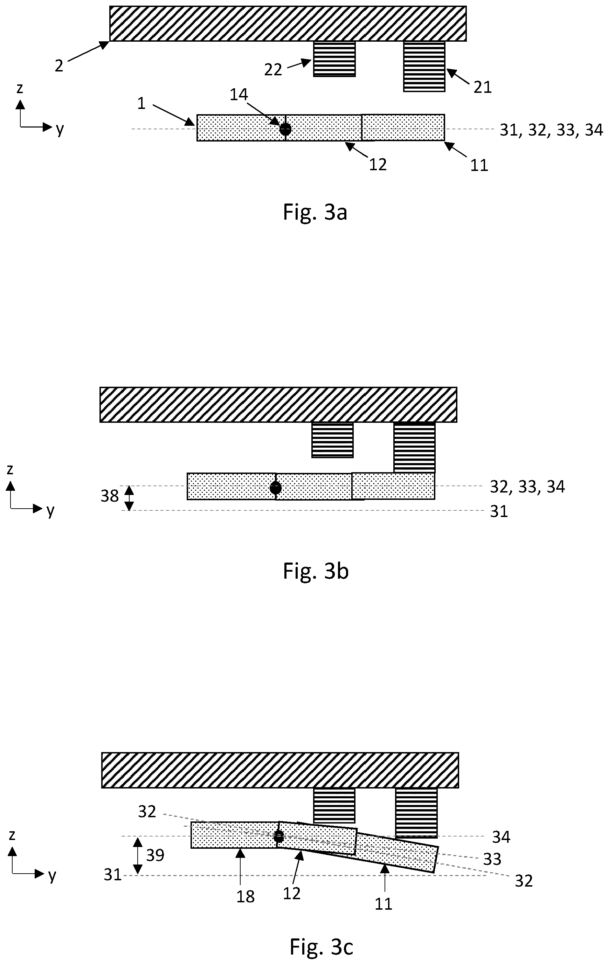

In all figures 2a - 2c and 3a - 3c, the dotted line 31 marks the xy-plane. The dotted line 32, which is also shown in figure 1a, illustrates the orientation (particularly the tilt angle) of the first stopper element 11. The dotted line 33, which is also shown in figure 1a, illustrates the orientation of the second stopper element 12. The dotted line 34, which is also shown in figure 1a, illustrates the orientation of the main body 18 of the mass element 1.

In the embodiment shown in figures 2a - 2c, the mobile mass element 1 is configured to undergo rotational motion about a rotation axis 28. Figure 2a illustrates the mass element 1 when it lies in the xy-plane. This may be the rest position of the mass element 1. Alternatively, the mass element 1 may be driven in continuous oscillatory motion. In that case, the position shown in figure 2a may be a zero-amplitude midpoint in the oscillating movement.

Figure 2b illustrates the positions of the mass element and the stopper elements at the first threshold, where the first stage of the motion limiter is activated. The mass element 1 has rotated about the rotation axis 28 so that the first stopper element 11 comes into contact with the first stopper bump 21. The angle 41 between the line 31 and all three lines 32, 33 and 34 in figure 2b is the first threshold, i.e. the rotation angle at which the first stage kicks in.

As the motion limiter begins to act in figure 2b, the movement of the mass element 1 will be retarded by the motion limiter. However, due to the flexibility of the motion limiter, the mass element will continue to rotate further due if its angular momentum is sufficiently large. However, the first stopper bump 21 prevents the first stopper element 11 from moving any further after they make contact. Referring to both figures 1a and 2b, due to (a) the continued rotation of mass element 1, (b) the force which the first stopper bump 21 imparts in the negative z-direction on the first stopper element 11, and (c) the flexibility of the torsionally flexible element 4, lines 33 and 34 will deviate from the line 32 after the first threshold, as figure 2c shows. In other words, the first stopper element 11 will no longer lie in the plane defined by the main body 18 of the mass element 1.

Furthermore, since the second stopper element 12 is also suspended from (attached to) the same torsionally flexible element 4, the twisting which takes place in the torsionally flexible element 4 (around the axis 14 in figure 1a) due to the force acting on the first stopper element 11 will also move the second stopper element 12 away from the plane defined by the main body 18 of the mass element 1. The line 33 will therefore also deviate from line 34. This phenomenon occurs as soon as the mass element continues its rotation from the position illustrated in figure 2b. It will occur even before the second stopper element 12 comes into contact with the fixed structure (in this case, with second stopper bump 22).

Consequently, the relative velocity between the second stopper element 12 and the fixed structure 2 (and the fixed second stopper bump 22) will, after the first threshold is crossed, be less than the relative velocity between the main body 18 of the mass element and the fixed structure (2, 22). The relative velocity between the second stopper element 12 and the second stopper bump 22 in this case comprises a combination of the angular rotation rate of stopper element 12 about the torsion axis 14 and the upward velocity of this torsion axis 14 (due to the rotation of the main body 18 of the mass element). The relative velocity between the main body 18 and the fixed structure (2, 22) comprises the angular rotation rate of the mass element 1 about the rotation axis 28.

Figure 2c illustrates the second threshold, where the second stage of the motion limiter is activated as the second stopper element 12 comes into contact with the second stopper bump 22. The angle 42 between the line 31 and line 34 in figure 2c is the second threshold, i.e. the rotation angle at which the second stage kicks in. The second stopper element 12 has already turned away from the plane defined by the main body 18 of the mass element 1 before the contact takes place, as explained above and illustrated in figure 2c. The line 33 therefore forms a smaller angle with line 31 than line 34 does.

The main body 18 of the mass element (which is not illustrated in full in figures 2a - 2c but may extend past the first and second stopper elements 11 and 12 on both sides, as figure 1a illustrates) should not come into contact with the fixed structure 2.

The illustrations in figures 2a - 2c are only schematic. The difference between lines 33 and 34 may in practice be smaller than figure 2c illustrates.

As mentioned above, the fixed structure may be a flat surface without any protruding bumps. If the stopper elements 11 and 12 extend beyond the edge of the mass element 1, as they do in figure 1b, the first and second stages of the motion limiter can be activated according to the principles illustrated in figures 2a - 2c even if no stopper bumps 21 and 22 are present on the fixed structure 2, without contact between the main body 18 of the mass element 1 and the fixed structure 2. Other stopper element geometries may require the presence of protruding stopper bumps such as 21 and 22 on the fixed structure 2.

In the embodiment shown in figures 3a - 3c, the motion of the mobile mass element 1 toward the fixed structure 2 comprises linear translation in the direction of the z-axis. Figure 3a illustrates the mass element 1 when it lies in the xy-plane. This may be the rest position of the mass element 1. Alternatively, the mass element 1 may be driven in continuous oscillatory motion. In that case, the position shown in figure 3a may be a zero-amplitude midpoint in the oscillating movement. The first and second stopper bumps 21 and 22 here extend to different z-coordinates. The first stopper bump 21, which extends further away from the fixed structure 2 than the second stopper bump 22, is also located further away (in the y-direction) from the torsion axis 14 than the second stopper bump 22.

Figure 3b illustrates the first threshold, where the first stage of the motion limiter is activated. The entire mass element 1 has moved linearly in the z-direction away from the xy-plane which is illustrated by dotted line 31. The first stopper element 11 makes contact with the first stopper bump 21 in figure 3b. In some cases, this may be enough to bring the mass element 1 to a halt, but as in the previous discussion, we will assume that the momentum of the main body 18 of the mass element 1 carries it further in the z-direction even after the first threshold has been crossed. The distance 38 between the line 31 and all three lines 32, 33 and 34 in figure 3b is the first threshold, i.e. the distance from the xy-plane at which the first stage kicks in.

As in the previous example, the twisting which takes place in the torsionally flexible element 4 (around the axis 14 in figure 1a) as the main body of the mass element continues to move toward the fixed structure 2 will also bend the second stopper element 12 away from the plane defined by the main body 18 of the mass element 1. The line 33 therefore deviate from line 34 between the first and second thresholds, even before the second stopper element 12 comes into contact with the second stopper bump 22.

The relative velocity between the second stopper element 12 and the fixed structure 2 will again, after the first threshold is crossed, be less than the relative velocity between the main body 18 of the mass element and the fixed structure 2. In this case, these relative velocities comprise the linear velocity of these elements with respect to the fixed structure 2.

Figure 3c illustrates the second threshold, where the second stage of the motion limiter is activated as the second stopper element 12 comes into contact with the second stopper bump 22. The distance 39 between the line 31 and line 34 in figure 3c is the second threshold, i.e. the distance at which the second stage kicks in. As in the previous example, the second stopper element 12 has already turned away from the plane defined by the main body 18 of the mass element 1 before the contact takes place at the second threshold. The line 33 therefore forms an angle with line 34 even before impact.

The illustrations in figures 3a - 3c are only schematic. The angles between the lines may in practice be smaller than in figure 3c.

In conclusion, in any embodiment presented in this disclosure, the first stage of the motion limiter already provides a soft impact due to the flexibility of the torsionally flexible element 4 (figures 2b and 3b). If the braking action imparted by the motion limiter on the mass element 1 during the first stage is not enough to stop the movement of the mass element 1, then the mass element 1 will continue moving all the way to the position illustrated in figures 2c and 3c, where the second stage is activated. The second stage of the motion limiter also provides a soft impact, not only due to the flexibility of element 4, but also due to the fact that the second stopper element 12 is already turning away from the second stopper bump 22 before the impact occurs, as figures 2c and 3c illustrate.

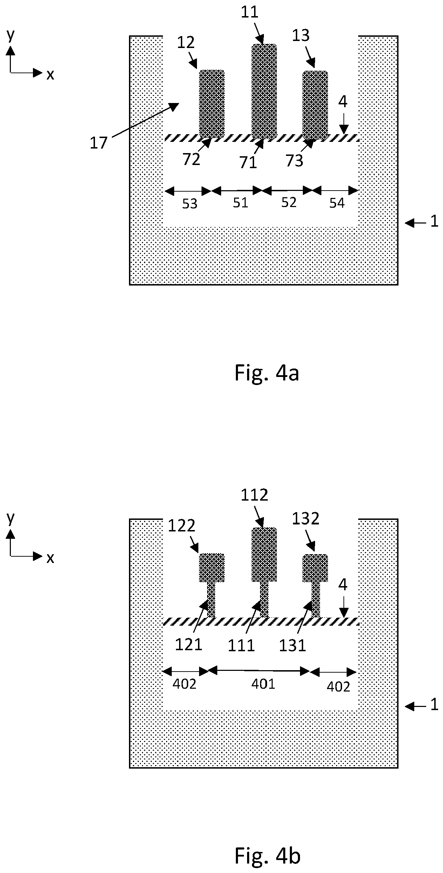

Additional stopper elements can be attached to the same torsionally flexible element. Figure 4a illustrates a microelectromechanical device where the first attachment point 71 lies substantially at the middle of the torsionally flexible element 4. The device comprises a third stopper element 13 on the mass element 1. The third stopper element 13 is attached to the torsionally flexible element 4 at a third attachment point 73. The motion limiter is configured to bring the third stopper element 13 into contact with the fixed structure when the mass element 1 crosses the second threshold.

The third stopper element 13 may have the same size and shape as the second stopper element 12, as figure 4a illustrates. In any out-of-plane embodiment presented in this disclosure, all stopper elements (such as 11 - 13) may extend to the same side of the flexible element 4.

In general, any stopper element presented in this disclosure may have the shape of a paddle or a shovel, as figure 4b illustrates. Here the first, second and third stopper elements comprise a first part (111, 121, 131) which is narrow (in the y-direction) and is attached to the torsionally flexible element 4. They also comprise a second part (112, 122, 132) which is wide (in the y-direction), and which is attached to the first part, so that the second part (112, 122, 132) lies further away from the torsionally flexible element 4 than the first part. (111, 121, 131). This geometry may be useful for reducing the size of the flexible element 4.

The second (12) and third (13) stopper elements may extend equally far from the torsionally flexible element 4 in the y-direction.

Furthermore, the second (72) and third (73) attachment points may lie on opposite sides of the first attachment point 71 on the torsionally flexible element 4. The distance 51 from the first attachment point 71 to the second attachment point 72 along the torsionally flexible element 4 may be equal to the distance 52 from the first attachment point 71 to the third attachment point 73 along the torsionally flexible element 4. Furthermore, the distance 53 from the second attachment point 72 to the edge of the gap 17 in mass element 1 may be equal to the distance 54 from the third attachment point 73 to the opposite edge of the gap 17 along the torsionally flexible element 4.

The benefit of a symmetric stopper element arrangement, such as the ones shown in figures 4a - 4b, where stopper elements 12 and 13 may engage simultaneously with the fixed structure when the second threshold is passed, is that the spring constants of the motion limiter in the various stages of the motion limiter can be more easily tailored. For example, the flexible element 4 in figure 4b has been divided into three sections 401 and 402. The torsional spring constant of section 401 may be less than the combined torsional spring constant of sections 402. The spring constant of the motion limiter in the first stage may then be determined primarily by the torsional flexibility of section 401, but also to some extent by the flexibility of sections 402. The spring constant of the motion limiter in the second stage may be determined primarily by the torsional flexibility of sections 402.

The torsional flexibility of each section can be designed independently of the flexibility of the other sections, for example by selecting suitable values for the width (in the y-direction) or height (in the z-direction) of the spring in that section. The spring constants acting in various stages of the motion limiter can, in both figures 1a - 1b and 4a - 4b and in the in-plane embodiments presented below be calculated with computer simulations.

The motion-limiting properties of the motion limiter can be designed according to need by giving suitable dimensions at least (a) to the torsionally flexible element 4, (b) to the first and second stopper elements 11 and 12, (c) the distances between their attachment points (d) to the distances between these attachment points and the sidewalls of the gap 17.

The moment of inertia of any stopper element with respect to the torsion axis 14 may be adjusted by changing its area in the xy-plane and/or its thickness in the z-direction. It is also possible to extend any stopper element to both sides of the torsionally flexible element 4 to decrease its moment of inertia.

In general, in any out-of-plane embodiment presented in this disclosure, the stopper elements 11 - 13 may extend away from the flexible element 4. Each stopper element 11 - 13 may impart a torque on the flexible element 4 after the stopper element has made contact with the fixed structure. The angle between each stopper element and the flexible element 4 may be substantially 90 degrees.

### In-plane motion

The mass element 1 may be configured to move toward the fixed structure 2 in a direction which lies in the device plane This in-plane motion may be linear translation motion in the direction of an axis which lies in the device plane. In the following examples of in-plane motion, it is assumed that the motion occurs in the direction of the y-axis.

In any out-of-plane embodiment the motion limiter may comprise a flexible element which extends between the first stopper element and the second stopper element. The flexible element also extends to the mass element. The flexible element may be more flexible than the stopper elements. Consequently, the spring constant of the motion limiter in any of its various stages may be determined by the flexibility of the flexible element in that stage.

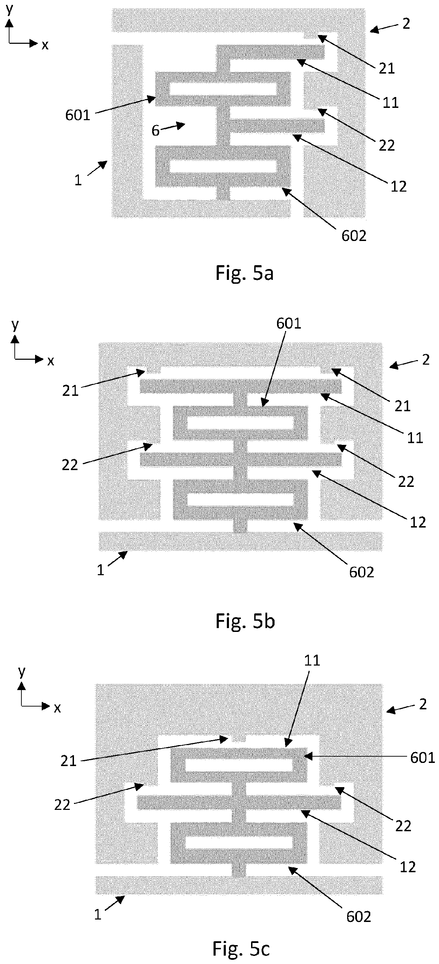

Figures 5a - 5c illustrates a motion limiter in the xy-plane. The mobile mass element 1 is shown on the left side and a fixed structure 2 on the right side. Only the edges of the mass element and the fixed structure are illustrated. The mass element 1 may be suspended from an adjacent fixed structure (which may be fixed structure 2, or some other fixed structure) by a flexible suspension structure (not illustrated). The suspension structure may be configured to allow the mobile mass element 1 to undergo linear motion in relation to fixed structure 2 in the direction of the y-axis in the xy-plane.

The motion limiters illustrated in figures 5a - 5c comprise a first stopper element 11 and a second stopper element 12 on the mass element 1. The motion limiter is configured to bring the first stopper element 11 into contact with the fixed structure (in this case, first stopper bumps 21) when the mass element crosses a first threshold while moving in the y-direction toward the fixed structure. The motion limiter is configured to bring the second stopper element 12 into contact with the fixed structure (second stopper bumps 22) when the mass element crosses a second threshold while moving in the y-direction toward the fixed structure.

The gap (in the y-direction) between the first stopper element and the fixed structure 2 (in this case, first stopper bump 21) is in each smaller than the gap between the second stopper element 12 and the second stopper bump 22. Consequently, the first threshold is reached when the mass element 1 has been displaced in the y-direction so much that the gap between 11 and 21 is closed. If the movement of the mass element 1 toward the fixed structure 2 continues, the second threshold is reached when gap between 12 and 22 is closed.

In all in-plane embodiments presented in this section, the motion limiter comprises a flexible element which extends in the device plane from the main body of the mass element toward the fixed structure. The first stopper element is attached to the flexible element at a first attachment point. The second stopper element is attached to the flexible element at a second attachment point. The second attachment point is closer to the main body of the mass element than the first attachment point.

In figures 5a - 5c, the flexible element 6 is a linearly compressible flexible element which extends from the main body of the mass element 1 toward the fixed structure 2. The first and second stopper elements 11 and 12 are connected to this element. The linearly compressible flexible element 6 comprises a first section 601 and a second section 602. The first and second sections may for example be leaf springs. The first section 601 may be more flexible in the y-direction than the second section 602. The motion limiter will then resist further movement of the mass element toward the fixed structure with a first spring constant when the first threshold has been crossed and with a second spring constant after the second threshold has been crossed, and the first spring constant will be smaller than the second spring constant. Figure 5c illustrates an option where the top of the first section 601 also acts as the first stopper element 11.

In general, in the embodiment presented in figures 5a - 5c, each stopper element 11 and 12 may impart a compressing force on the flexible element 6 after the stopper element has made contact with the fixed structure. At least one of the first and second stopper elements 11 and 12 may extend away from the flexible element. The angle between those stopper elements (which extend away from the flexible element) and the flexible element 6 may be substantially 90 degrees.

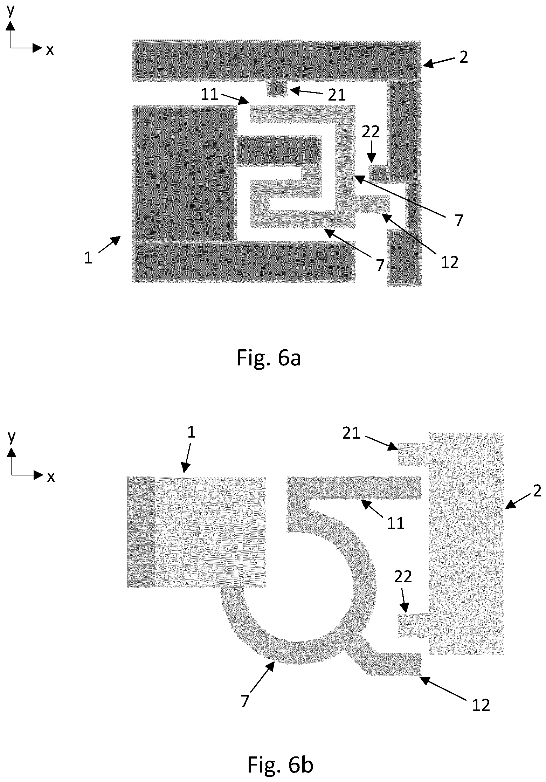

Figures 6a - 6b illustrate another embodiment where the flexible element is a rotationally flexible element 7 which extends in an arc from the main body of the mass element toward the fixed structure.

Figure 6a illustrates a device where the flexible element 7 has a substantially spiral shape. The first and second stopper elements 11 and 12 extend in opposite directions from the flexible element 7. In other words, the first stopper element 11 extends in the negative x-direction, while the second stopper element 12 extends in a positive x-direction. The first and second stopper elements 11 and 12 could alternatively both extend in the positive x-direction. In either case, when the mass element 1 moves upward in the positive y-direction, the end of the first stopper element 11 will pressed in the negative y-direction after the first threshold has been passed. The first threshold occurs at the point where the first stopper element 11 makes contact with the first stopper bump 21.

Due to the action of the flexible element 7, the force applied by the first stopper bump 21 on the first stopper element 11 will also shift the second stopper element 12 in the negative y-direction even before the second threshold (where the second stopper element 12 makes contact with the second stopper bump 22) is reached. The entire flexible element 7 resists further movement of the mass element 1 between the first and second thresholds and after the second threshold. The spring constant of the flexible element 7 is larger after the second threshold than between the first and second thresholds.

Figure 6b illustrates a device where the flexible element 7 has a substantially circular shape. After the first threshold is crossed, the flexible element will undergo motion which approximates clockwise rotational in-plane motion. As in figure 6a, the velocity of the second stopper element 12 in the y-direction with respect to the fixed structure 2 will therefore be less than the velocity of the mass element 1 with respect to the fixed structure 2 between the first and second thresholds. As in figure 6a, the flexible element 7 resists further movement of the mass element 1 between the first and second thresholds and after the second threshold. The spring constant of the flexible element 7 is larger after the second threshold has been crossed than between the first and second thresholds.

In figures 5a - 5c and 6a - 6b, the stopper elements 11 and 12 may be substantially rigid in the y-direction. They may be so rigid that a force which acts on either stopper element 11 or 12 in the y-direction (after the stopper element has come into contact with the fixed structure 2) will be transmitted to the flexible element 6 and 7 without bending said stopper element 11 or 12 significantly.

Alternatively, the stopper elements 11 and 12 may be dimensioned so that they bend after the first and second stopper elements 11 and 12 have come into contact with the fixed structure at the first and second thresholds.

Any stopper element described in the preceding in-plane and out-of-plane embodiments may have an elongated shape. The motion limiter may be configured so that the fixed structure will come into contact with a first end of the stopper element and/or with the middle of the stopper element. A second end of the stopper element, which is opposite to the first end, may be attached to the flexible element. Furthermore, the first and second stopper elements may in these embodiments extend in the same direction from the flexible element, or in opposite directions.

In general, in the embodiment presented in figures 6a - 6b, each stopper element may impart a torque on the flexible element 7 after the stopper element has made contact with the fixed structure 2. At least one of the first and second stopper elements 11 and 12 may extend away from the flexible element 7. The angle and geometry of those stopper elements (which extend away from the flexible element) may be such that at least the first end of each stopper element is parallel with the x-axis.

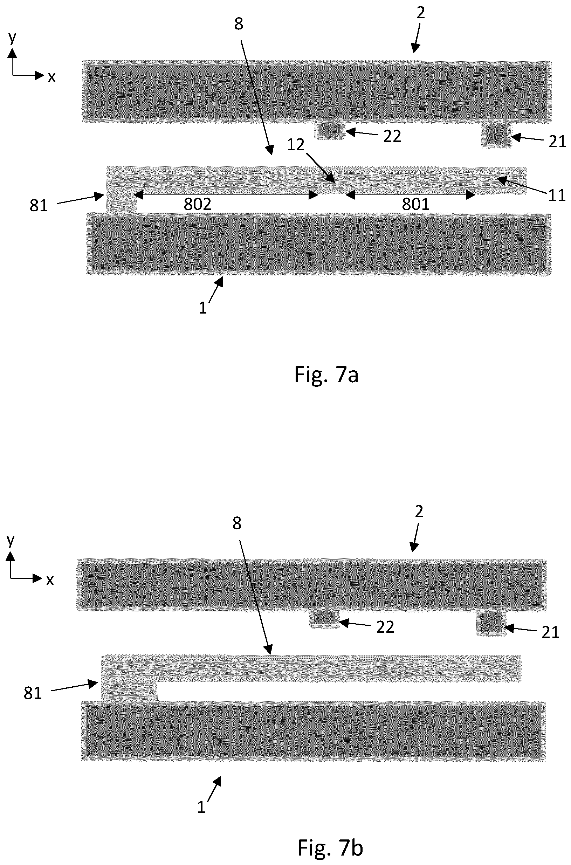

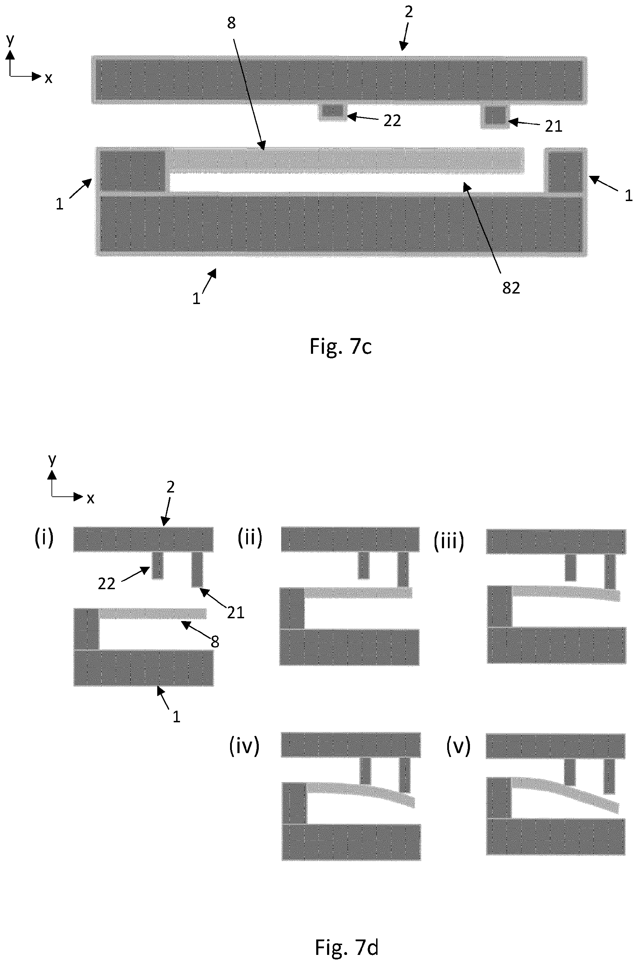

Figure 7a illustrates an alternative embodiment where the flexible element is a cantilever spring 8 on an edge of the mass element 1. The cantilever spring 8 may lie between the mass element 1 and the fixed structure 2. The cantilever spring 8 may be bend flexibly in the y-direction along its entire length, wherein length is measured in the x-direction.

It can be seen in figure 7a that a first stopper bump 21 extends closer to the cantilever spring 8 than a second stopper bump 22. The first stopper element 11 is in this case a region on the cantilever spring 8 which comes into contact with the first stopper bump 21 when the motion limiter reaches its first threshold. The second stopper element 12 is a region on the cantilever spring 8 which comes into contact with the second stopper bump 22 when the motion limiter reaches its second threshold.

As figure 7a illustrates, the motion limiter may have a base 81 which is stiff in the y-direction and first and second sections 801 and 802 which extend in the x-direction and are flexible in the y-direction. The first section 801 of the cantilever spring 8 extends between the first stopper element 11 and the second stopper element 12 on the cantilever spring 8. The second section 802 of the cantilever spring 8 extends between the second stopper element 12 and the base 81.

When the first threshold has been reached, but the second threshold has not yet been reached, both the first and second sections 801 and 802 of the cantilever spring 8 contribute to the flexibility of the motion limiter. After the second threshold has been reached, the second section 802 determines the flexibility of the motion limiter. The spring constant of the second section 802 on its own is greater than the spring constant of first and second sections 801 and 802 together.

The width of the cantilever spring 8 in the movement direction (the y-direction) may be substantially equal along its entire length. In other words, first and second sections 801 and 802 may have the same width. Alternatively, the width of the first section 801 in the y-direction may be less than the width of the second section.

The width of the base 81 (in the x-direction) in figure 7a is substantially equal to the width of the cantilever spring 8 in the y-direction. Figure 7b illustrates an alternative design where the width of the base 81 is substantially wider, for example more than 50% wider, than the width of the cantilever spring 8.

The cantilever spring does not necessarily have to be attached to a base which protrudes from the edge of the mass element. Figure 7c illustrates an alternative design where the mass element 1 comprises an opening 82 at its edge, and the cantilever spring is attached to the mass element 1 in this opening.

Figure series 7d illustrates the action of any motion limiter shown in figures 7a - 7c. Figure (i) shows the parts of the motion limiter before impact. Figure (ii) shows the motion limiter at the point where the mass element 1 has moved to the first threshold and the cantilever spring 8 makes contact with the first stopper bump 21. As the mass element 1 continues moving, the motion limiter resists this movement with the first spring constant in figure (iii), as the cantilever spring 8 bends along its entire length.

In figure (iv) the mass element has moved so far that it reaches the second threshold and the cantilever spring 8 makes contact with the second stopper bump 22. As the mass element continues to move even further in figure (v), the motion limiter now resists the movement with the second spring constant as the part of the cantilever spring which is to the left of the second stopper bump 22 bends.

### Additional options

As explained earlier, the motion limiter may be configured to resist further movement of the mass elements toward the fixed structure with a first spring constant after the first threshold has been crossed but the second threshold has not yet been crossed. The motion limiter may resist further movement of the mass elements toward the fixed structure with a second spring constant after the second threshold has been crossed. The first spring constant may differ from the second spring constant.

The first spring constant K1 may be smaller than the second spring constant K2. The ratio K2 / K1 may for example be in the range 1.5 - 3, or in the range 1.2 - 5.

In general, the spring constant of the flexible element in the motion limiter at a given stage is determined by the couplings (which may be parallel, series, or a combination of the two) between the flexible element and the stopper elements in that stage. For example, with reference to figures 4a - 4b, all sections 401-402 contribute to the first spring constant K1. But once the second stage of the motion limiter is activated (and assuming that stopper elements 12 and 13 both belong to the second stage), there is little or no relative movement between stopper elements 11, 12 and 13, and therefore little or no further twisting in section 401. Only sections 402 then contribute to the second spring constant K2, which makes K2 greater than K1.

The same general principle applies in all the in-plane motion limiters. For example, in figures 5a - 5c there is little or no further compression in section 601 after the second stage has been activated. Sections 601 and 602 both contribute to the first spring constant K1, but first section 601 does not contribute to the second spring constant K2. The second spring constant will therefore be greater than the first.

This principle can be expanded to further stages in the motion limiter, if they are present: after stage N is triggered, where N is an integer greater than one, some sections of the flexible element which contributed to the spring constant in stage N - 1 may undergo no further deformation. The spring constant will be greater in stage N than in stage N - 1 due to this lack of further deformation.

In any embodiment presented in this disclosure, additional stopper elements can be incorporated into any stage of the motion limiter. These additional stopper elements will then make contact with the fixed structure at the same time as the other stopper elements in that stage. For example, the third stopper element 13 in figures 4a - 4b may be used in the same stage as the first stopper element 11 if the third stopper bump which it strikes extends to a lower z-coordinate than the first stopper bump.

An alternative solution in figure 4b is to incorporate the third stopper element 13 to the second stage, so that it makes contact with a third stopper bump at the same time as the second stopper element 12 makes contact with the second stopper bump 22. Finally, the third stopper element 13 could also be used as a third stage in the motion limiter by delaying its impact with the stopper bump until after the second threshold has been crossed.

In general, in any embodiment the additional stopper elements may alternatively form a third, fourth, N:th stage in the motion limiter, with corresponding third, fourth, N:th thresholds. In all of these cases, they are configured to make contact with the fixed structure in sequence after the second threshold has been crossed.

In other words, the motion limiter may comprise third, fourth, N:th stopper elements which are attached to the flexible element. N is an integer. The motion limiter may be configured to bring the third, fourth, N:th stopper elements into contact with the fixed structure at the first or second thresholds. Alternatively, the motion limiter may be configured to bring the third, fourth, N:th stopper elements into contact with the fixed structure in sequence when the mass element crosses third, fourth, N:th thresholds while moving toward the fixed structure. The mass element may be closer to the fixed structure at each successive threshold than it was at the previous one.

The motion limiter may be configured to move all additional stopper elements incorporated into stage N in relation to the main body of the mass element when the stopper element that form stages 1... N-1 come into contact with the fixed structure. The relative velocity between these additional stopper elements and the fixed structure then decreases at each stage of the motion limiter (assuming that the momentum of the mass element is so high that its movement does not stop), until the additional stopper element finally makes contact with the fixed structure when stage N is activated.

## Claims

1. A microelectromechanical device comprising:
- a device layer which defines a device plane
- a mobile mass element in the device layer, wherein the mass element comprises a main body,
- a fixed structure which is adjacent to the mass element,
- a motion limiter on the mass element, wherein the motion limiter comprises a first stopper element and a second stopper element,
wherein the motion limiter is configured to bring the first stopper element into contact with the fixed structure when the mass element crosses a first threshold while moving toward the fixed structure, and
the motion limiter is configured to bring the second stopper element into contact with the fixed structure when the mass element crosses a second threshold while moving toward the fixed structure,
wherein the mass element is closer to the fixed structure at the second threshold than at the first threshold,
**characterized in that** the motion limiter is configured to
• resist further movement of the main body of the mass element toward the fixed structure with a first spring constant when the first threshold has been crossed but the second threshold has not yet been crossed, and
• resist further movement of the main body of the mass element toward the fixed structure with a second spring constant after the second threshold has been crossed,
wherein the first spring constant is smaller than the second spring constant.

2. A microelectromechanical device according to claim 1, wherein the mass element in configured to move toward the fixed structure in a direction which is perpendicular to the device plane.

3. A microelectromechanical device according to claim 2, wherein the mass element comprises a gap, and the motion limiter comprises a torsionally flexible element which extends across the gap, and the first stopper element is attached to the torsionally flexible element at a first attachment point, and the second stopper element is attached to the torsionally flexible element at a second attachment point.

4. A microelectromechanical device according to claim 3, wherein the first stopper element extends further away from the torsionally flexible element than the second stopper element extends.

5. A microelectromechanical device according to any of claims 3-4, wherein the torsionally flexible element has a first element region and a second element region, and the width in the device plane of the torsionally flexible element in the first element region is greater than the width in the device plane of the torsionally flexible element in the second element region.

6. A microelectromechanical device according to any of claims 3-5, wherein the torsionally flexible element has a first element region and a second element region, and the thickness in the direction perpendicular to the device plane of the torsionally flexible element in the first element region is greater than the thickness in the direction perpendicular to the device plane of the torsionally flexible element in the second element region.

7. A microelectromechanical device according to any of claims 3-4, wherein the torsionally flexible element has uniform width and uniform thickness.

8. A microelectromechanical device according to any of claims 3-7, wherein the first attachment point lies substantially in the middle of the torsionally flexible element.

9. A microelectromechanical device according to any of claims 3-8, wherein the device comprises a third stopper element on the mass element, and the third stopper element is attached to the torsionally flexible element at a third attachment point, and the motion limiter is also configured to bring the third stopper element into contact with the fixed structure when the mass element crosses the second threshold.

10. A microelectromechanical device according to claim 9, wherein the second and third attachment points lie on opposite sides of the first attachment point on the torsionally flexible element.

11. A microelectromechanical device according to any of claims 9-10, wherein the second and third stopper elements extend equally far from the torsionally flexible element.

12. A microelectromechanical device according to any of claims 9-11, wherein the distance from the first attachment point to the second attachment point along the torsionally flexible element is equal to the distance from the first attachment point to the third attachment point along the torsionally flexible element.

13. A microelectromechanical device according to claim 1, wherein the mass element is configured to move toward the fixed structure in a direction which lies in the device plane.

14. A microelectromechanical device according to claim 13, wherein the motion limiter comprises a flexible element which extends in the device plane from the main body of the mass element toward the fixed structure, and the first stopper element is attached to the flexible element at a first attachment point, and the second stopper element is attached to the flexible element at a second attachment point, and the second attachment point is closer to the main body of the mass element than the first attachment point.

15. A microelectromechanical device according to claim 14, wherein the flexible element is a linearly compressible flexible element which extends from the main body of the mass element toward the fixed structure.

16. A microelectromechanical device according to claim 14, wherein the flexible element is a rotationally flexible element which extends in an arc from the main body of the mass element toward the fixed structure.

17. A microelectromechanical device according to claim 16, wherein the flexible element has a substantially circular shape.

18. A microelectromechanical device according to claim 14, wherein the flexible element is a cantilever spring on an edge of the mass element, and the cantilever spring is flexible in the device plane along its entire length.
